# EUROPÄISCHE PATENTANMELDUNG

(11) **EP 1 172 854 A2**
(43) Veröffentlichungstag der Anmeldung: **16.01.2002**
(21) Anmeldenummer: 01114531.5
(22) Anmeldetag: 16.06.2001
(51) Int. Cl.: H01L 27/105

(54) **Halbleiterspeicher mit wahlfreiem Zugriff**

(30) Priorität: 13.07.2000 DE 10034083
(71) Anmelder: Infineon Technologies AG, 81669 München (DE)
(72) Erfinder: Gogl, Dietmar, 12524 Fishkill, NY (US); Roehr, Thomas, Dr., 85609 Aschheim (DE); Hoenigschmid, Heinz, East Fishkill, NY 12524 (US)
(74) Vertreter: Patentanwaltskanzlei WILHELM & BECK

(57) **Zusammenfassung**

Die Erfindung betrifft eine Speichermatrix, die mindestens ein Zellenfeld aus sich kreuzenden Spalten und Zeilenleitungen aufweist. An den Schnittpunkten der Zeilen und Spaltenleitungen befinden sich jeweils Speicherelemente. Jeweils zwei voneinander benachbarte Leitungen sind so miteinander überkreuz geführt, dass die beiden Leitungen abschnittsweise ihre Anordnungen in Verlaufsrichtung ändern, um das Überkoppeln von Signalen auf den betreffenden Leitungen zu minimieren.

## Beschreibung

Die Erfindung betrifft Speichermatrizen, insbesondere Speichermatrizen für MRAMs, d.h. nichtflüchtige magnetische Speicherelementen aus magnetischen Tunnelelementen, gemäß dem Oberbegriff des Patentanspruchs 1.

Halbleiterspeicher mit wahlfreiem Zugriff weisen üblicherweise ein Zellenfeld aus einer Matrix von Spalten- und Zeilenleitungen auf, an deren Schnittpunkten sich jeweils eine Speicherzelle befindet. Bei einem MRAM werden als Speicherelemente typischerweise magnetische Tunnelelemente verwendet.

Ein solches TMR-Element (TMR: Tunnelmagnetwiderstand; engl.: tunneling magneto resistance) besteht im Prinzip aus zwei Magnetschichten, einer hartmagnetischen und einer weichmagnetischen Schicht. Diese sind durch eine isolierende Zwischenschicht mit einer Dicke von nur wenigen Atomlagen voneinander getrennt. Die Magnetisierungen in den beiden Schichten können sowohl gleichgerichtet als auch gegeneinander gerichtet sein. Die isolierende Barriere zwischen den Magnetschichten ist so dünn, dass nach Anlegen einer Spannung einige Elektronen hindurch gelangen können; es fließt ein sogenannter Tunnelstrom. Die Stärke des Tunnelstroms hängt dabei von der Orientierung der Magnetisierungsrichtungen zueinander ab.

Aus einem solchen TMR-Element lassen sich Daten auslesen, ohne dass dessen Speicherzustand verändert wird. Beschrieben wird ein solcher Speicher, indem man durch Anlegen von elektrischem Strom die Magnetisierungsrichtung der sogenannten "weichen" Magnetschicht festlegt. Durch die Richtung des Stroms wird der Inhalt des Speicherelements bestimmt. Die benötigten Ströme sind besonders beim Schreiben relativ hoch (ca. 2,5mA), da die Magnetisierung durch das Magnetfeld eines stromdurchflossenen Leiters bewirkt werden muss.

Beim Beschreiben eines TMR-Speicherelements fließen elektrische Ströme durch die entsprechenden Spalten- und Zeilenleitungen, wobei nur die Spalten- und Zeilenströme gemeinsam die Magnetisierung der weichen Magnetschicht ändern können. Zum Lesen des Inhalts einer Speicherzelle wird eine Spannung auf die Wortleitung gegeben und der Spannungsabfall über dem Tunnelwiderstand gemessen, der den Inhalt der Speicherzelle repräsentiert.

Bei Halbleiterspeichern ist das Decodieren der Adressen schaltungstechnisch weniger aufwendig, wenn die jeweils selektierten Spaltenleitungen direkt nebeneinander liegen. Diese werden dann bei einem Zugriff, jedoch auch gleichzeitig angesprochen und mit einem entsprechenden Signal beaufschlagt. Es tritt dann das Problem auf, dass bei einer Stromänderung, z.B. Einschalten des Stromflusses, auf einer Leitung durch induktive Kopplung auf der Nachbarleitung ein entsprechender Störstromimpuls induziert wird. Dies ist besonders schädlich, wenn auf den benachbarten Leitungen entgegengesetzte Ströme fließen, weil die induzierten Störströme dann dem eigentlichen Schreibstrom genau entgegenwirken. Die Störung der benachbarten Leitungen ist besonders groß, wenn sich auf den benachbarten Leitungen die logischen Pegel "Null" und "Eins" miteinander abwechseln, d. h. sich die Stromrichtung umkehrt.

Es ist daher Aufgabe dieser Erfindung, die negative Wirkung des Überkoppelns einer Leitung auf eine benachbarte Leitung zu reduzieren.

Diese Aufgabe wird erfindungsgemäß durch Anspruch 1 gelöst.

Dadurch, dass erfindungsgemäß die jeweils benachbarten Leitungen ihre Anordnungen in Verlaufsrichtung ändern, wird erreicht, dass sich hinsichtlich einer Leitung mindestens eine der benachbarten Leitungen ändert. Dies führt dazu, dass eine Leitung nicht über das gesamte Zellenfeld hinweg die gleichen Nachbarleitungen hat. Bei einer gleichzeitigen Adressierung von benachbarten Leitungen, wie dies üblicherweise bei
Adressdecodierern vorkommt, ist dies von Vorteil, weil somit unerwünschte Überkopplungseffekte zwischen zwei Leitungen reduziert werden können.

Weitere vorteilhafte Ausführungsformen sind in den abhängigen Ansprüchen angegeben.

Vorteilhafterweise besteht dieses Ändern der Anordnung von nebeneinanderliegenden Leitungen darin, dass jeweils zwei Leitungen überkreuzt werden, da eine Überkreuzung von zwei benachbarten Leitungen technologisch am einfachsten zu realisieren ist.

Eine Ausführungsform der Erfindung besteht darin, dass die Speichermatrix ein erstes und zweites Zellenfeld aufweist, die in Lagen übereinander gestapelt sind, wobei sich die Spalten bzw. Zeilenleitungen von unterschiedlichen Lagen im wesentlichen gegenüberliegen. Eine solche Stapelung hat den Vorteil, dass sich die Speicherdichte pro Chipfläche erhöhen lässt.

Bevorzugt kann vorgesehen sein, dass eine Leitung mehrfach mit einer beliebigen und nicht immer derselben einer jeweils daneben angeordneten Spalten- bzw. Zeilenleitungen überkreuzt wird, d.h. ihre Anordnung tauscht. Dadurch kann eine weitere Reduzierung der Kopplungswerte zwischen den ursprünglich nebeneinander angeordneten Leitungen erreicht werden.

Neben der Änderung der Anordnung von Leitungen innerhalb einer Speicherlage kann bei einer solchen mehrlagigen Ausführung eine solche Anordnungsänderung auch bezüglich Leitungen einer anderen Speicherlage erfolgen. Dies dient dazu, den negativen Effekt der Überkopplung zwischen benachbarten Leitungen von einander gegenüberliegenden Speicherlagen zu reduzieren.

Bei einer weiteren Ausführungsform erfolgt die Änderung der Anordnung von jeweils verschiedenen nebeneinanderliegenden Spalten bzw. Zeilenleitungen nur untereinander in einem Teilbereich der Spalten- und Zeilenleitungen, der bei einem Speicherzugriff aktiviert wird. Dies ist vorteilhaft, weil so mit einer geringen Anzahl von Anordnungsänderungen eine möglichst hohe Entkopplung zwischen den Leitungen des Teilbereichs erreicht werden kann. Es reicht aus, nur das Überkoppeln innerhalb dieser Segmente, d.h. mehrere nebeneinanderliegende oder logisch einander zugeordnete Leitungen, zu reduzieren, weil die Segmente nur nacheinander adressiert werden. Nur gleichzeitig adressierte Leitungen können sich gegenseitig beeinflussen. Nicht geschaltete oder stromlose Leitungen haben keinen wesentlichen Einfluss auf die Schalteigenschaften der aktiven Leitungen. Die aktiven Leitungen beeinflussen auch nicht die Inhalte der Speicherelemente an den benachbarten nicht aktiven Leitungen. Trotzdem wird eine relativ gute Entkopplung für eine Vielzahl möglicher Bitmuster erreicht.

Bevorzugt kann vorgesehen sein, dass die Speichermatrix hinsichtlich der Änderungen der Anordnung ihrer Leitungen so aufgebaut ist, so dass die Reihenfolge der Spalten- bzw. Zeilenleitungen an gegenüberliegenden Rändern der Speichermatrix gleich ist. Dadurch kann ein zusätzlicher Schaltungsaufwand bei der Realisierung von Adressdecodierern vermieden werden, der entsteht, wenn die Adressleitungen ungeordnet sind oder eine Reihenfolge aufweisen, die von der ursprünglichen abweicht. Dies ist insbesondere deshalb von Bedeutung, da im Falle von MRAM-Speichern eine Beschaltung der Spalten- und Zeilenleitungen an beiden Rändern des Zellenfelds zweckmäßig ist. Vorzugsweise kann weiterhin vorgesehen sein, dass die Zellenfelder bzw. deren Spalten- bzw. Zeilenleitungen hinsichtlich ihrer Anordnungsänderungen spiegelsymmetrisch sind.

Weiterhin kann vorgesehen sein, dass der Randbereich des Zellenfeldes Leitungen umfasst, die ihre Anordnungen nicht ändern.

Die Erfindung wird im folgenden anhand der Zeichnungen und Tabellen sowie der Beschreibung der bevorzugten Ausführungsformen erläutert. Es zeigen:
- Fig. 1a: ein magnetisches TMR-Element nach dem Stand der Technik;
- Fig. 1b: zwei magnetische TMR-Elemente, die in zwei Lagen übereinander angeordnet sind;
- Tab. 2a: einen Ausschnitt aus einem Zellenfeld ohne Überkreuzung der Leitungen nach dem Stand der Technik;
- Fig. 2b: eine Tabelle, die die Größenordnungen der Überkopplungen zwischen den Spaltenleitungen bei einem Zellenfeld nach Fig. 2a darstellt;
- Fig. 3a: einen Ausschnitt aus einem Zellenfeld mit Überkreuzung von jeweils zwei benachbarter Spaltenleitungen;
- Tab. 3b: eine Tabelle, die die Größenordnung der Überkopplung zwischen den Spaltenleitungen bei einem Zellenfeld nach Fig. 3a darstellt;
- Fig. 4a: einen Ausschnitt aus einem Zellenfeld mit mehrfacher Überkreuzung von mehreren Bitleitungen;
- Tab. 4b: eine Tabelle, die die Größenordnungen der Überkopplungen zwischen den Spaltenleitungen bei einem Zellenfeld nach Fig. 4a darstellt;
- Fig. 5: eine spiegelsymmetrische Anordnung von zwei Zellenfeldern gemäß Fig. 4a, wobei die Reihenfolge der Spaltenleitungen am oberen Rand gleich der am unteren Rand entspricht;
- Fig. 6a-6h: ein Paket von vier Spaltenleitungen, die bei einem Speicherzugriff gemeinsam aktiviert werden, wobei die Spaltenleitungen nur innerhalb dieses Pakets überkreuzt sind;
- Fig. 7a-7c: günstige Überkreuzungskonstellationen bei Paketgrößen von 4, 8 bzw. 16 Spaltenleitungen;
- Fig. 8a: eine mögliche Anordnung zweier Zellenfelder, bei der jeweils zwei Speicherelemente übereinander gestapelt sind;
- Fig. 8b: zwei Zellenfelder nach Fig. 8a mit Spaltenleitungen, die miteinander überkreuzt sind.

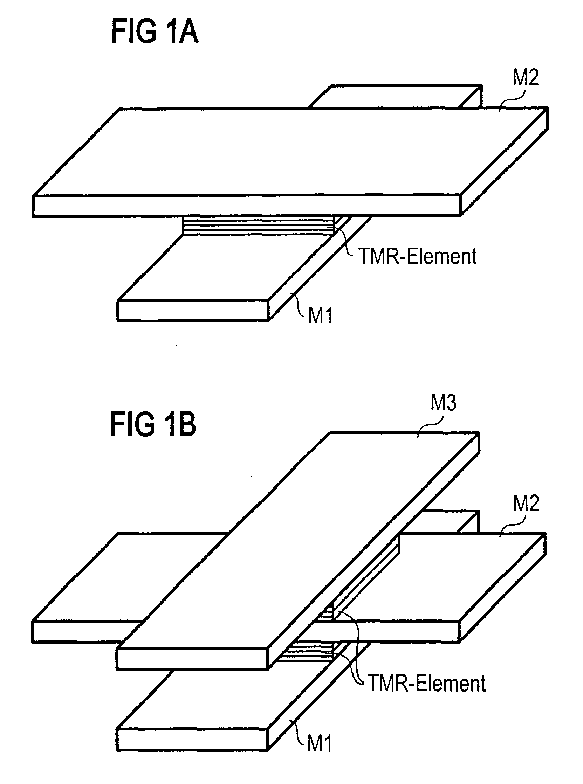

In Fig. 1a ist ein TMR-Element nach dem Stand der Technik bildlich dargestellt, wobei M1 und M2 die Spalten- und Zeilenleitungen zum Adressieren, Beschreiben und Auslesen eines Speicherelements darstellen. Durch Übereinanderstapelung mehrerer solcher Speicherelemente lässt sich die Speicherdichte pro Chipfläche erhöhen. In Fig. 1b ist dies für zwei Lagen gezeigt. Hierfür wurde eine weitere Spaltenleitungsebene M3 eingefügt. Auch eine Stapelung von mehr als zwei TMR-Elementen ist denkbar.

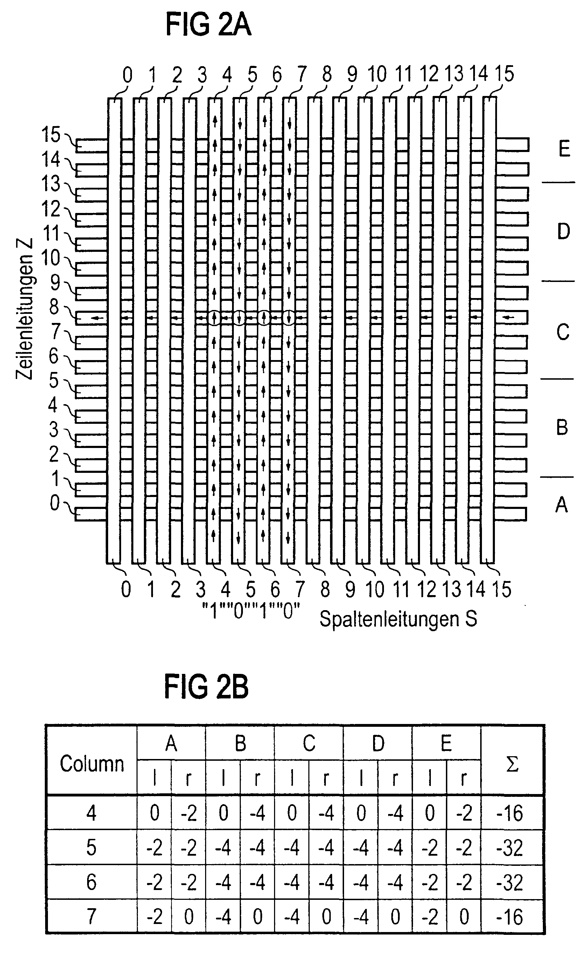

Typischerweise werden in Halbleiterspeichern pro Adresse nicht nur ein, sondern mehrere Bits gespeichert, d.h. innerhalb eines Zellenfelds eines Halbleiterspeichers werden gleichzeitig mehrere Speicherzellen gelesen oder beschrieben. In Fig. 2 ist ein Beispiel für das gleichzeitige Schreiben in vier TMR-Zellen eines MRAM gezeigt.

Im gezeigten Beispiel fließen Schreibströme durch die Spaltenleitungen 4, 5, 6 und 7 sowie durch eine Zeilenleitung 7, so dass die vier durch Kreise gekennzeichneten Speicherzellen beschrieben werden. Je nachdem, ob eine "Null" oder logische "Eins" geschrieben werden soll, ist die Flussrichtung des Stroms durch die Spaltenleitungen negativ oder positiv und somit die jeweilige Magnetisierung gleichgerichtet oder entgegengesetzt zur Magnetisierung der hartmagnetischen Schicht gerichtet. Im Beispiel in Fig. 2 wird in die Spaltenleitungen 4 und 6 eine "Eins" und in die Spaltenleitungen 5 und 7 eine "Null" eingeschrieben.

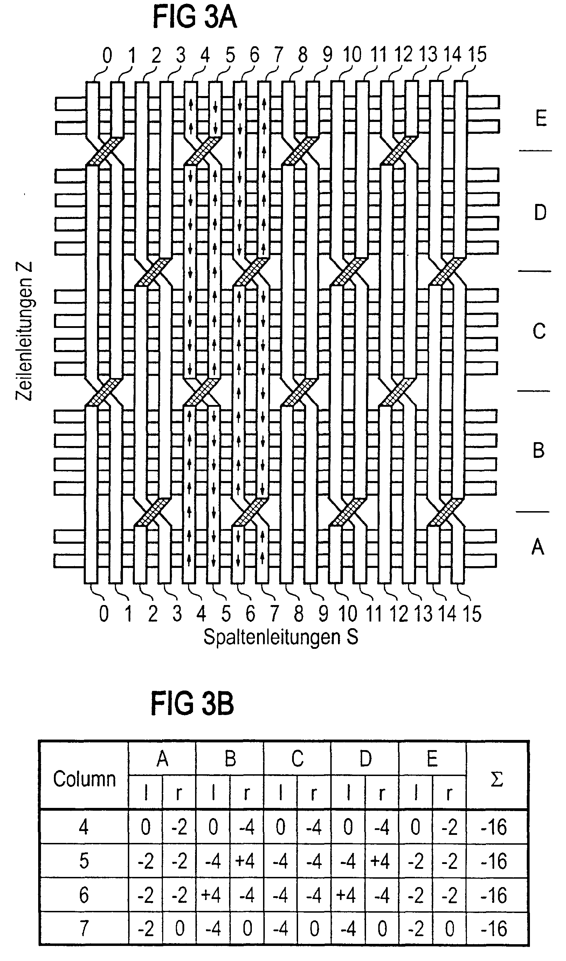

In einer ersten erfindungsgemäßen Ausführungsform, die in Fig. 3a gezeigt ist, ist ein nichtflüchtiger magnetischer Halbleiterspeicher aus einer Matrix von Spalten- S und Zeilenleitungen Z aufgebaut. An den Schnittpunkten jeder Spalten- S und Zeilenleitung Z befindet sich das TMR-Element. In der gezeigten Ausführungsform werden jeweils zwei benachbarte Spaltenleitungen S ein- oder mehrmals miteinander überkreuzt, so dass diese im weiteren Verlauf ihre Positionen tauschen. Wie bereits oben ausgeführt, ändert sich dadurch für eine überkreuzte Leitung mindestens eine ihrer direkten Nachbarleitungen. Im Falle des oben betrachteten, in Fig. 3a durch die Markierung A gekennzeichneten Beispiels bewirkt die Überkreuzung der Leitungen 2 und 3, dass sich die Konstellation der Nachbarleitungen für die Leitungen 1,2,3 und 4 gleichzeitig ändert.

Stromänderungen auf benachbarten Leitungen wirken sich durch Überkopplung auf benachbarte Leitungen aus, indem ein Wechselmagnetfeld erzeugt wird, das seinerseits einen Stromfluss in benachbarten Leitungen induziert. Im Falle einer Speichermatrix aus Spalten- und Zeilenleitungen kommt es vor allem beim Beschreiben mehrerer Speicherelemente durch Ströme auf benachbarten Spaltenleitungen zu störenden Induktionsströmen. Je größer die Länge ist, über die sich zwei benachbarte etwa parallele Leitungen beeinflussen können, desto höher sind die dort induzierten Störströme. Insbesondere bei den relativ hohen Schreibströmen bei MRAMs von beispielsweise 2,5mA können diese Überkopplungseffekte die Funktionsweise des Bauelements beeinträchtigen, oder zumindest den Schreibzyklus erheblich verlangsamen, da der erforderliche Stromfluss erst nach dem Abklingen der induzierten Störung vorliegt.

Durch das Überkreuzen benachbarter Leitungen wird nun erreicht, dass sich Stromänderungen nicht über die gesamte Länge der Leitung beeinflussen und somit der negative Effekt der Überkopplung reduziert wird.

Bei genauer Betrachtung der Spaltenleitungen 4 und 5 der Zellenmatrix der Fig. 3a erkennt man, dass die Verläufe der Spaltenleitungen 4 und 5 sich zweifach überkreuzen. Ebenso sind auch die benachbarten Spaltenleitungspaare 2 und 3 bzw. 6 und 7 so miteinander überkreuzt, dass die Stelle deren Überkreuzungen zu den Überkreuzungen der Spaltenleitungen 4 und 5 versetzt liegen. Dies hat zur Folge, dass sich in dem gezeigten Ausführungsbeispiel die Nachbarleitungen der Spaltenleitungen 4 und 5 viermal über die Sektoren A bis E verändern. Im Beispiel der Spaltenleitung 4 ändern sich die jeweils benachbarten Spaltenleitungen von Spaltenleitungen 3 und 5 in Sektor A, zu den Spaltenleitungen 2 und 5 in Sektor B, zu den Spaltenleitungen 5 und 7 in Sektor C, zu den Spaltenleitungen 5 und 6 in Sektor D und wieder zu den Spaltenleitungen 3 und 5 in Sektor E.

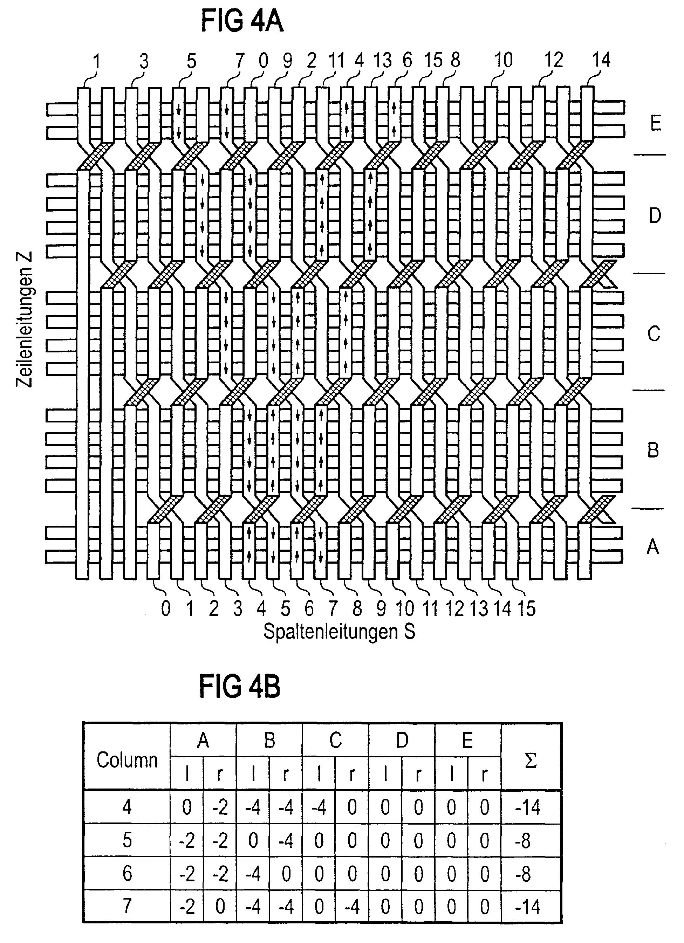

In den Tabellen 2b,3b und 4b sind die Größenordnungen der Überkopplungen für das gezeigte Bitmuster 1010 eines gleichzeitig geschriebenen Datenpaketes für Zellenfelder mit nicht überkreuzten Leitungen (Fig. 2a), mit jeweils paarweise überkreuzten Leitungen (Fig. 3a) sowie mit untereinander mehrfach überkreuzten Leitungen (Fig. 4a) abgeschätzt. Ist die Stromflussrichtung benachbarter Leitungen entgegengesetzt, ist der Betrag "-1", bei gleichförmiger Stromflussrichtung "+1" und bei stromloser Nachbarleitung "0" - jeweils bezogen auf eine Längeneinheit - (hier eine Zeile). Niedrigere Beträge der Kopplungswerte bedeuten eine geringere Überkopplung.

Bei der Anordnung der Fig. 2a ohne Überkreuzungen ergibt sich bei dem betrachteten Leitungspaket (Leitungen 4 bis 7) ein Kopplungswert für die Randleitungen (4 und 7) von -16 und für die Leitungen (5 und 6) in der Mitte ein Kopplungswert von - 32.

Für die Anordnung der Fig. 3a, bei der jeweils ein Leitungspaar Überkreuzungen aufweist, reduziert sich der Kopplungswert für alle Leitungen gleichmäßig auf -16.

Ein weiteres Ausführungsbeispiel ist in Fig. 4a gezeigt. Die Überkreuzung zweier benachbarter Spaltenleitungen erfolgen dort nicht nur untereinander, sondern auch jeweils so, dass auch ursprünglich nicht nebeneinander liegende Spaltenleitungen in ihrem Verlauf miteinander überkreuzt werden. Wir betrachten zunächst die stromführenden Leitungen 4 bis 7. Zwischen den Bereichen A und B sind zunächst die nebeneinanderliegenden Spaltenleitungspaare 4 und 5 bzw. 6 und 7 miteinander überkreuzt, wonach die anfänglich (in Bereich A) innenliegenden Leitungen 4 und 5 nun jeweils die stromlosen Nachbarleitungen 2 und 9 aufweisen. Zwischen den Bereichen B und C sind dann jedoch die Leitungspaare 2 und 5, 4 und 7 bzw. 6 und 9 miteinander überkreuzt, und man erkennt, dass die ursprünglich innenliegenden Leitungen 5 und 6 nun keine stromführende Nachbarleitungen aufweisen. Zwischen den Bereichen C und D werden die Leitungspaare 0 und 5, 2 und 7, 4 und 9 und 6 und 11 miteinander überkreuzt, usw.. Dadurch werden alle ursprünglich nebeneinander liegenden Leitungen voneinander separiert. Wie aus Fig. 4b ersichtlich, reduzieren sich die errechneten Kopplungswerte auf -14 bzw. -8.

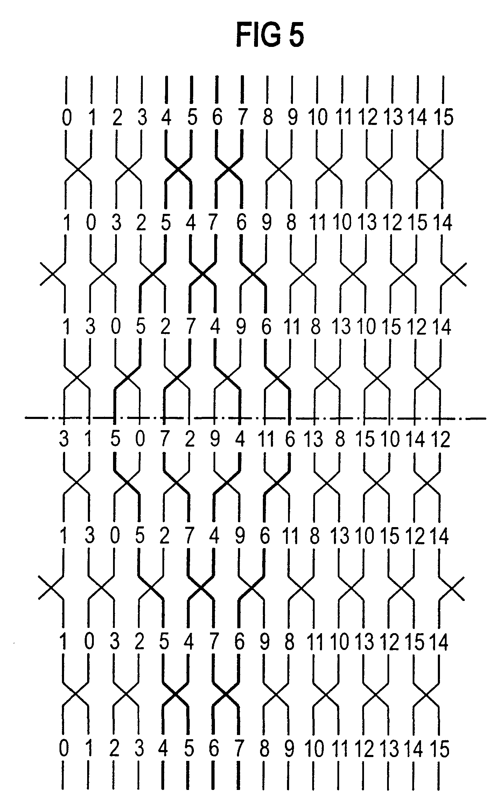

Dieses Überkreuzungsschema führt allerdings dazu, dass die Reihenfolge der Spaltenleitungen am oberen Rand der Matrix nicht identisch zu der am unteren Rand ist. Um das Decodieren der Adressen, d.h. die Zuordnung der Speicheradresse zu den ausgewählten Spaltenleitungen 4,5,6 und 7, schaltungstechnisch möglichst einfach, d.h. mit möglichst geringem Flächenaufwand, zu gestalten, ist es jedoch von Vorteil, dass die ausgewählten Spaltenleitungen direkt nebeneinander liegen. Das sollte möglichst für beide Enden der Spaltenleitungen erreicht werden, da zur Kompensation von parasitären Strömen eine beidseitige Beschaltung der jeweiligen Leitungen zweckmäßig ist. Bei Fig. 4a ist die Reihenfolge der Spaltenleitungen am oberen Ende der Zellenmatrix ungeordnet und ein Adressdecodierer deshalb aufwendig zu realisieren. Dieser Nachteil kann dadurch behoben werden, dass man zwei Zellenfelder mit demselben Überkreuzungsschema spiegelbildlich aneinander setzt. Dies wird in Fig. 5 schematisch dargestellt, wobei die gestrichelte Linie die gedachte Spiegellinie darstellt. Die Reihenfolge der Spaltenleitungen S am oberen Rand entspricht der Reihenfolge der Spaltenleitungen S am unteren Rand.

Bei einem weiteren Ausführungsbeispiel kann vorgesehen sein, dass die Überkreuzungen nur innerhalb von mehreren neben- oder übereinander angeordneten Leitungen ausgeführt werden. Dies kann deswegen zweckmäßig sein, weil ein Speicherzugriff blockweise erfolgt und jeweils nur die neben- oder übereinander angeordneten Spaltenleitungen gleichzeitig aktiviert werden.

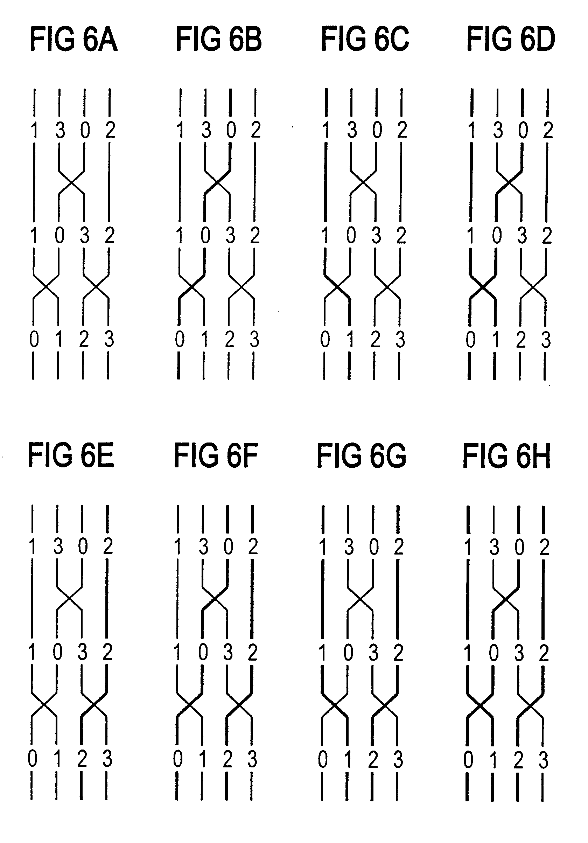

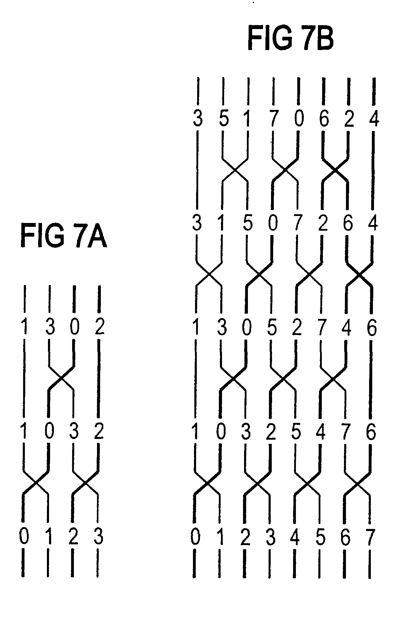

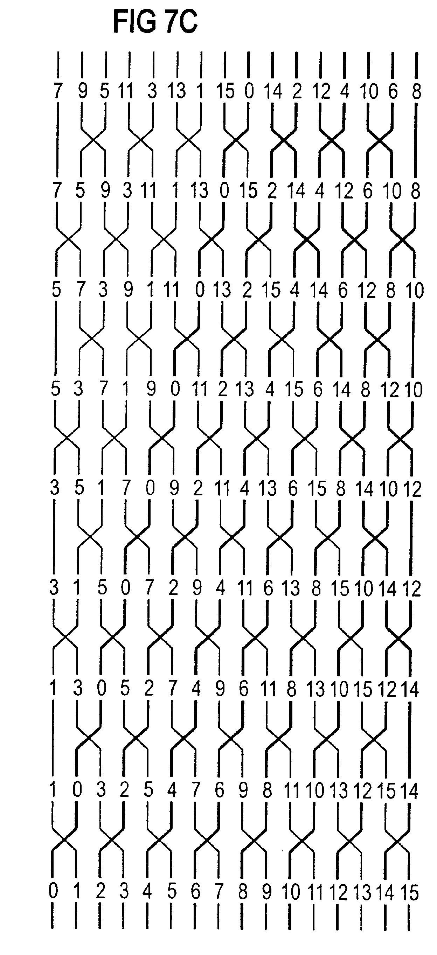

Fig. 6a-6h zeigen die Überkreuzung in einem Paket von vier Spaltenleitungen. Die dünn dargestellten Leitungen entsprechen hier einer logischen "Null" bzw. einem negativen Stromfluss, die dick ausgeführten Leitungen einer logischen "Eins" bzw. einem positiven Stromfluss. Man erkennt, dass sich für alle gezeigten Bitmuster eine relativ gleichmäßige Verteilung benachbarter und nicht benachbarter Bereiche sowie der Randbereiche ergibt. Die vier Leitungen sind daher für alle möglichen Bitmuster relativ gut entkoppelt. Diese günstige Konstellation wird für vier Leitungen nach zwei Überkreuzungen erreicht (Fig. 7a), bei acht Leitungen sind vier Überkreuzungen notwendig (Fig. 7b), bei 16 Leitungen acht Überkreuzungen (Fig. 7c) oder allgemein bei 2ⁿ Leitungen 2ⁿ⁻¹ Überkreuzungen. Dadurch kann man die Zahl der Überkreuzungen vermindern und gleichzeitig eine gute und gleichmäßige Reduzierung der Überkopplung gewährleisten.

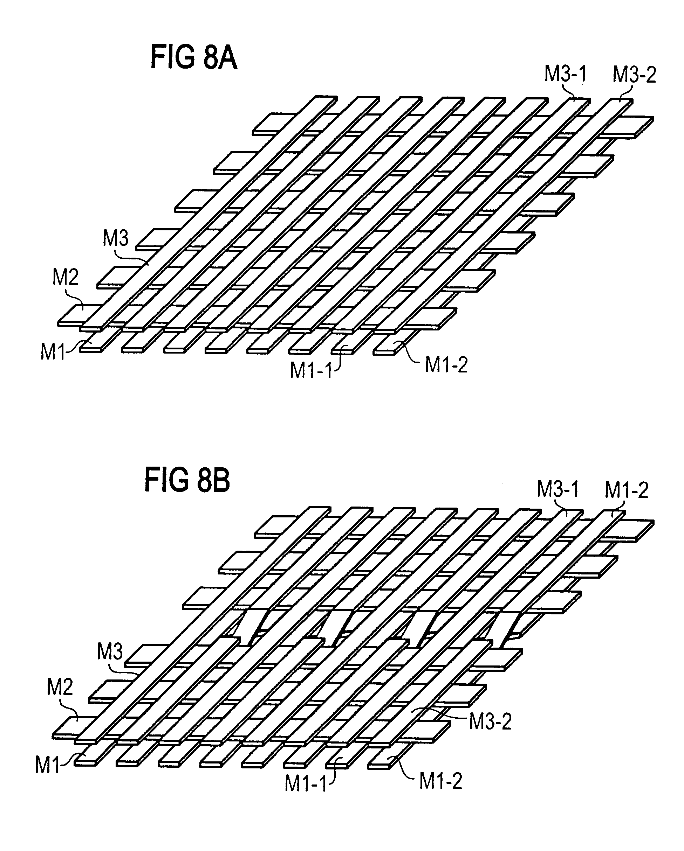

Fig. 8a zeigt eine Ausführungsform, bei der zwei Zellenfelder aufeinander gestapelt sind, d.h. es gibt eine Zeilenebene M2 und zwei Spaltenebenen M1, M3. Die Spaltenleitungen M1-1, M3-1 bzw. M1-2 der Ebenen M1 und M2 laufen jeweils über die gesamte Länge parallel zueinander. In der Anordnung nach Fig. 8b sind die Spaltenleitungen M1-1 und M3-1 miteinander überkreuz geführt, so dass die Spaltenleitungen M3-1 und M3-2 nur zur Hälfte ihrer Längen direkt benachbart verlaufen, wodurch das Überkoppeln zwischen diesen beiden Leitungen reduziert wird.

MRAM-Speicher können auch mit mehr als zwei Lagen realisiert werden, das Konzept der Überkreuzung übereinanderliegender Spaltenleitungen bzw. dann auch Zeilenleitungen ist sinngemäß entsprechend anwendbar. Selbstverständlich können Überkreuzungen innerhalb einer Zellenebene auch mit Überkreuzungen zwischen zwei Zellenebenen kombiniert werden.

Selbstverständlich ist es für den Fachmann auch denkbar, nicht nur direkt benachbarte Leitungen zu überkreuzen, sondern auch Leitungen, die nicht direkt zueinander benachbart sind, in ihren Anordnungen zu ändern. Dadurch kann man erreichen, dass sich nicht nur ein Teil der benachbarten Leitungen ändert, sondern je nach Größe der Änderung bis zu allen benachbarten Leitungen, wodurch man eine noch größere Entkopplung der Leitungen erhält.

Die in der vorangehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen wesentlich sein.

## Patentansprüche

1. Speichermatrix, die mindestens ein Zellenfeld aus Spaltenleitungen und Zeilenleitungen aufweist, an deren Schnittpunkten sich jeweils Speicherelemente befinden, wobei jeweils die Zeilenleitungen und/oder die Spaltenleitungen eines Zellenfelds nebeneinander angeordnet sind,
**dadurch gekennzeichnet,**
**dass** mindestens zwei Spalten- oder Zeilenleitungen ihre Anordnung zueinander ändern.

2. Speichermatrix nach Anspruch 1, **dadurch gekennzeichnet, dass** die mindestens zwei Spalten- oder Zeilenleitungen überkreuzt sind.

3. Speichermatrix nach einem der Ansprüche 1 oder 2, **dadurch gekennzeichnet, dass** die Speicherelemente nichtflüchtige magnetische TMR-Elemente sind.

4. Speichermatrix nach einem der vorangehenden Ansprüche, **dadurch gekennzeichnet, dass** sie ein erstes und ein zweites Zellenfeld aufweist, die in Lagen übereinander gestapelt sind, wobei jeweils die Spalten- bzw. Zeilenleitungen von verschiedenen Lagen sich im wesentlichen benachbart gegenüberliegen.

5. Speichermatrix nach einem der vorangehenden Ansprüche, **dadurch gekennzeichnet, dass** mindestens eine der Spaltenbzw. Zeilenleitungen über ihre Länge mehrfach mit mindestens zwei verschiedenen, nebeneinander angeordneten und/oder einander gegenüberliegenden Spalten- bzw. Zeilenleitung überkreuzt ist.

6. Speichermatrix nach einem der vorangehenden Ansprüche, **dadurch gekennzeichnet, dass** benachbarte Spalten- bzw. Zeilenleitungen jeweils nur innerhalb eines bei einem Speicherzugriff gleichzeitig aktivierten Teilbereichs von Spalten- bzw. Zeilenleitungen miteinander überkreuzt sind.

7. Speichermatrix nach einem der vorangehenden Ansprüche, **dadurch gekennzeichnet, dass** mindestens eines der Zellenfelder so aufgebaut ist, so dass die Reihenfolge der Spalten- bzw. Zeilenleitungen an gegenüberliegenden Rändern der Speichermatrix gleich ist.

8. Speichermatrix nach Anspruch 7, **dadurch gekennzeichnet, dass** mindestens eines der Zellenfelder hinsichtlich der Anordnungen der Spalten- und/oder der Zeilenleitungen spiegelsymmetrisch ist.

9. Speichermatrix nach einem der vorangehenden Ansprüche, **dadurch gekennzeichnet, dass** im Randbereich eines der Zellenfelder keine Änderung der Anordnung der Spalten- oder Zeilenleitungen erfolgt.
